# FASCICULE DE BREVET EUROPEEN

(11) **EP 1 963 783 B1**
(45) Date de publication et mention de la délivrance du brevet: **17.06.2020**
(21) Numéro de dépôt: 06847117.6
(22) Date de dépôt: 22.12.2006
(51) Int. Cl.: G01C 19/5747, H03H 9/02

(54) **MICROSYSTEME, PLUS PARTICULIEREMENT MICROGYROMETRE, AVEC AU MOINS DEUX MASSES OSCILLANTES COUPLEES MECANIQUEMENT**
MIKROSYSTEM, INSBESONDERE MIKROKREISELS MIT MINDESTENS ZWEI MECHANISCH GEKOPPELTEN SCHWINGMASSEN
MICROSYSTEM, MORE PARTICULARLY A MICROGYRO, WITH AT LEAST TWO MECHANICALLY COUPLED OSCILLATING MASSES

(30) Priorité: 23.12.2005 FR 0513215
(43) Date de publication de la demande: 03.09.2008
(73) Titulaire: Commissariat à l'Énergie Atomique et aux Énergies Alternatives, 75015 Paris (FR)
(72) Inventeur: DIEM, Bernard, 38130 Echirolles (FR)
(74) Mandataire: Talbot, Alexandre
(86) Numéro de dépôt international: PCT/FR2006/002846
(87) Numéro de publication internationale: WO 2007/077353

(56) Documents cités:
- FR-A- 2 809 174
- US-A- 5 635 638
- US-A1- 2004 154 397
- US-A1- 2005 072 231
- US-A1- 2005 229 705

## Description

### Domaine technique de l'invention

L'invention concerne un microsystème, plus particulièrement un microgyromètre, réalisé dans un substrat plan et comportant :
- au moins deux masses oscillantes, reliées au substrat par des moyens élastiques de suspension,
- et des moyens de couplage de deux masses oscillantes adjacentes, aptes à produire un mouvement en opposition de phase desdites masses oscillantes, lors de leur excitation selon une direction d'excitation prédéterminée.

### État de la technique

Dans le domaine des microsystèmes, du type capteurs ou actionneurs, il est connu d'utiliser un microgyromètre, pour la mesure inertielle de la vitesse de rotation. Un microgyromètre utilise classiquement la force de Coriolis, générée par une masse en vibration sous l'effet d'une rotation, pour mesurer la vitesse. La force de Coriolis est engendrée dans une direction perpendiculaire à la vibration d'excitation et à l'axe de rotation.

Un microgyromètre est un composant micro-usiné, de préférence, dans le plan d'un substrat, et comportant classiquement au moins deux masses oscillantes, entraînées par tout moyen d'excitation approprié dans une même orientation d'oscillation, mais dans un sens de déplacement opposé (déplacement en opposition de phase). Les masses oscillantes intègrent classiquement des éléments de détection dans leur structure, destinés à la détection de la force de Coriolis.

Il existe deux grandes familles de détection. La première famille consiste à une détection dans le plan du substrat sur lequel est réalisé le microgyromètre, avec un axe de rotation perpendiculaire au substrat. La seconde famille consiste à une détection perpendiculaire au plan du substrat, avec un axe de rotation dans le plan du substrat.

Pour des raisons technologiques de simplicité et de coût, un microgyromètre à détection dans le plan du substrat est le plus souvent utilisé. À titre d'exemple, les documents WO-A-9605480, WO-A-2004042324 et le brevet US 6752017 décrivent chacun un microgyromètre à excitation et détection dans le plan du substrat.

Le document WO-A-2004042324 décrit notamment un microgyromètre avec un couplage des masses oscillantes par des ressorts, permettant d'effectuer la détection dans une seule direction. Cependant, ce type de couplage réduit considérablement la sensibilité du microgyromètre.

Le brevet US 6752017 décrit notamment un microgyromètre avec un système de couplage des masses oscillantes permettant de séparer les modes de vibration en phase et en opposition de phase. Cependant, l'efficacité de mesure est moindre et le fonctionnement du microgyromètre n'est pas optimal.

Pour améliorer le fonctionnement d'un microgyromètre, il est connu d'effectuer une mesure différentielle, c'est-à-dire effectuer une mesure de la force de Coriolis lorsque les masses oscillantes sont excitées en opposition de phase. Il est donc nécessaire de forcer la vibration des masses à une fréquence plus élevée que la fréquence fondamentale.

À titre d'exemple, les brevets US 5635638, US 5728936 et US 5241861 proposent chacun un microgyromètre, dont le mode de vibration en opposition de phase est forcé.

Le brevet US 5635638 décrit notamment un microgyromètre à excitation et détection dans le plan du substrat, avec un système de couplage des masses par des poutres. Cependant, une asymétrie du système est observée, ce qui conduit à des mouvements beaucoup moins maîtrisés des masses oscillantes.

Les brevets US 5728936 et US 5241861 décrivent chacun un microgyromètre avec un système de couplage par liaison des angles opposés des masses oscillantes, par l'intermédiaire d'un lien en rotation, pour forcer le mode de vibration en opposition de phase. Cependant, ce type de microgyromètre est très difficile à mettre en œuvre et la détection s'avère peu efficace, car elle ne participe pas à la masse inertielle du microgyromètre.

Les microgyromètres décrits ci-dessus fonctionnent soit à une fréquence autre que la fréquence fondamentale soit avec un déplacement imposé, égal et opposé des masses oscillantes, qui s'avère très restrictif pour le contrôle de la technologie de fabrication des microgyromètres.

Par ailleurs, le document US 2004/154397 décrit également un microgyromètre avec deux masses oscillantes, destinées à osciller en opposition de phase, pour déterminer notamment la vitesse de rotation. Les masses oscillantes sont reliées à un substrat par des moyens de suspension, lesquels sont couplés entre eux par des barres de liaisons. Cependant, un tel microgyromètre est à détection perpendiculaire au plan du substrat et la position des barres de liaison est dissymétrique. Il en résulte notamment un fonctionnement perturbé du microgyromètre.

Le document US 2005/072231 décrit également un microsystème, plus particulièrement un capteur de vitesse angulaire, comportant deux masses oscillantes sur un substrat, reliées par des branches d'interconnexion déformables et par des branches d'interconnexion rigides. Cependant, une telle liaison des masses oscillantes par des branches rigides impose notamment un déplacement parfaitement identique des deux masses oscillantes en opposition de phase, ce qui est pratiquement impossible d'un point de vue fonctionnement.

Le document US 2005/0229705 décrit un capteur inertiel comportant deux masses oscillantes reliées par une barre de couplage. La barre de couplage est fixée aux masses oscillantes par des éléments de flexion. La barre de couplage est fixée à deux autres éléments de flexion par l'intermédiaire d'un point de pivot.

Ainsi, quel que soit le microgyromètre connu, il n'offre pas un fonctionnement optimal.

### Objet de l'invention

L'invention a pour but de remédier à l'ensemble des inconvénients précités et a pour objet la réalisation d'un microsystème à masses oscillantes couplées, plus particulièrement un microgyromètre avec deux masses oscillantes, qui soit simple de conception, facile à mettre en œuvre et qui présente un fonctionnement optimal.

Le but de l'invention est atteint par une microstructure selon les revendications annexées. Plus particulièrement :
- le microsystème comporte au moins une paire de moyens élastiques de suspension, disposés sur des côtés opposés de deux masses oscillantes adjacentes et ayant un axe de plus faible raideur orienté dans ladite direction d'excitation,
- lesdits moyens de couplage connectent des zones intermédiaires de ladite paire de moyens élastiques de suspension,
- chaque zone intermédiaire est disposée entre une première extrémité des moyens élastiques de suspension associés, fixée sur la masse oscillante correspondante, et une seconde extrémité des moyens élastiques de suspension associés, fixée sur le substrat par un point d'ancrage correspondant,
- lesdites zones intermédiaires, connectées par les moyens de couplage, sont disposées de part et d'autre d'un axe parallèle à la direction d'excitation.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement une vue de dessus d'un mode particulier de réalisation d'un microsystème selon l'invention, plus particulièrement un microgyromètre, avec deux masses oscillantes couplées mécaniquement.
La figure 2 représente schématiquement une vue de dessus partielle très agrandie des moyens de couplage des masses oscillantes du microgyromètre selon la figure 1.
Les figures 3 à 5 représentent différentes variantes de réalisation de l'articulation en rotation des moyens de couplage du microgyromètre selon les figures 1 et 2.
La figure 6 représente schématiquement une vue de dessus d'une variante de réalisation d'un microsystème selon l'invention, plus particulièrement un microgyromètre, avec deux masses oscillantes couplées mécaniquement.

### Description de modes particuliers de réalisation

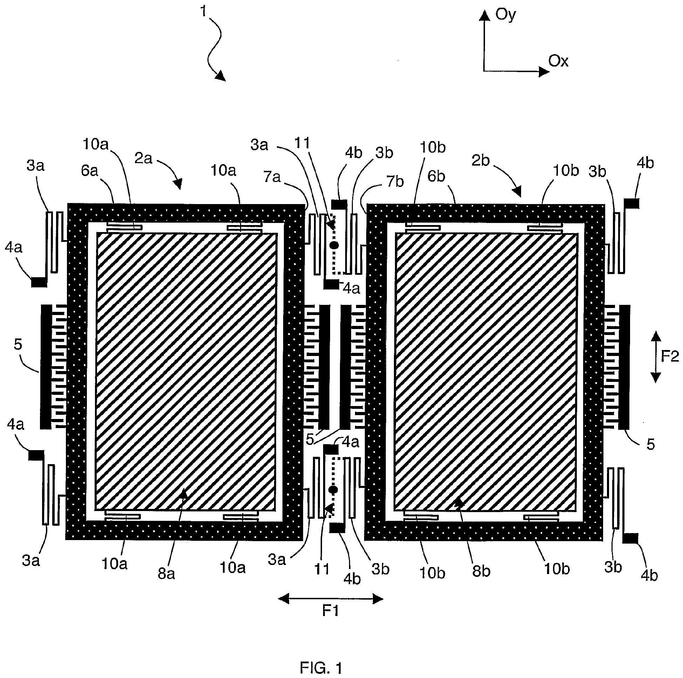

En référence aux figures 1 à 6, le microsystème 1 est, plus particulièrement, un microgyromètre destiné à la détermination d'une vitesse de rotation, par la mesure de la vibration de masses oscillantes couplées mécaniquement. Le microgyromètre 1 est réalisé, par exemple, par micro-usinage dans un substrat plan (non représenté sur les figures pour des raisons de clarté), définissant le plan de représentation des figures 1 à 6.

Dans le mode particulier de réalisation selon l'invention représenté sur la figure 1, le microgyromètre 1 comporte, de préférence, deux masses oscillantes 2a, 2b, de forme générale sensiblement rectangulaire, et, de préférence, identiques et symétriques sur elles-mêmes et l'une par rapport à l'autre. Chaque masse oscillante 2a, 2b est suspendue élastiquement sur le substrat par l'intermédiaire de ressorts de suspension 3a, 3b.

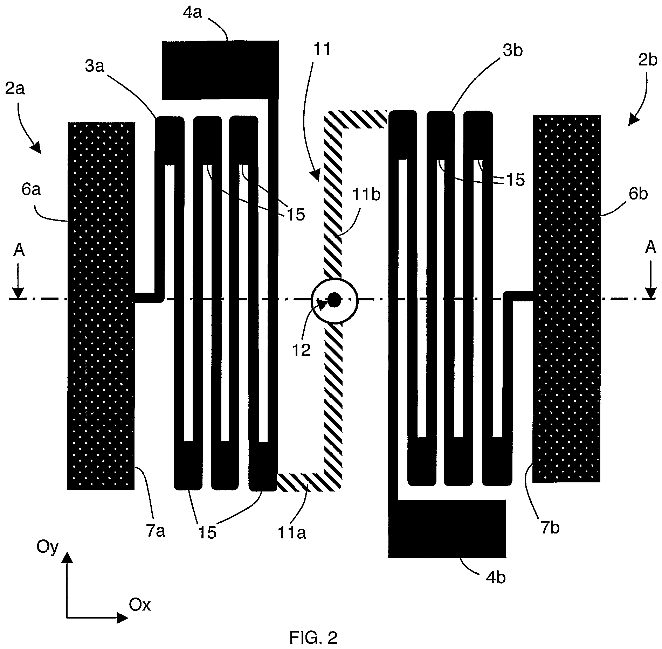

Sur les figures 1 et 2, les ressorts de suspension 3a, 3b sont des ressorts en forme de serpentin présentant, dans un même plan parallèle au substrat, une ou plusieurs branches successives en U. Les ressorts de suspension 3a, 3b sont ancrés à leur première extrémité sur les masses oscillantes 2a, 2b et à leur seconde extrémité sur le substrat, par l'intermédiaire de points d'ancrage 4a, 4b correspondants.

Sur la figure 1, chaque masse oscillante 2a, 2b est suspendue sur le substrat, respectivement, par quatre ressorts de suspension 3a, 3b et quatre points d'ancrage 4a, 4b correspondants. À titre d'exemple, les points d'ancrage 4a, reliant la masse oscillante 2a au substrat, sont disposés sensiblement vers la partie centrale de la masse oscillante 2a. Les points d'ancrage 4b, reliant la masse oscillante 2b au substrat, sont disposés sensiblement vers l'extérieur et aux quatre coins de la masse oscillante 2b.

Chaque masse oscillante 2a, 2b est entraînée en vibration dans une direction d'excitation Ox, selon la flèche F1, par l'intermédiaire, par exemple, de peignes capacitifs interdigités 5, disposés de part et d'autre de chaque masse oscillante 2a, 2b.

Comme représenté sur la figure 1, chaque masse oscillante 2a, 2b forme un cadre d'excitation 6a, 6b, sur lequel sont fixées les premières extrémités des ressorts de suspension 3a, 3b et les peignes capacitifs interdigités 5. Les cadres 6a, 6b présentent ainsi deux côtés opposés, respectivement 7a, 7b, perpendiculairement à la direction d'excitation Ox. Les côtés opposés 7a, 7b sont destinés à être couplés mécaniquement et présentent chacun, de préférence, deux ressorts de suspension 3a, 3b.

Les masses oscillantes 2a, 2b comportent chacune également des moyens de détection, participant à la masse inertielle, entourés par les cadres d'excitation 6a, 6b et composés, respectivement, d'un élément de détection 8a, 8b mobile.

Chaque élément de détection mobile 8a, 8b est relié au cadre d'excitation 6a, 6b correspondant par des ressorts élastiques de rappel 10a, 10b, qui autorisent un degré de liberté selon l'axe Oy. Chaque électrode mobile 8a, 8b vibre dans la direction Oy, selon la flèche F2 (figure 1), définissant l'axe de détection de la force de Coriolis, engendrée par la vibration des masses oscillantes 2a, 2b.

Ainsi, lors d'une rotation du substrat selon l'axe Oz, perpendiculaire au plan Ox/Oy définis par le substrat (figure 1), l'élément de détection 8a, 8b mobile va vibrer, selon la flèche F2, à la même fréquence que l'excitation des masses oscillantes 2a, 2b selon la flèche F1. Le déplacement de l'élément de détection 8a, 8b est alors mesuré, pour déterminer ensuite la vitesse de rotation.

Dans le mode particulier de réalisation de la figure 2, les deux masses oscillantes 2a, 2b du microgyromètre 1 sont couplées mécaniquement, de manière à produire un mouvement en opposition de phase, lors de leur excitation selon la direction d'excitation Ox.

Chaque ressort de suspension 3a du côté 7a du cadre d'excitation 6a associé à la masse oscillante 2a est couplé à un autre ressort de suspension 3b disposé en regard sur le côté opposé 7b du cadre d'excitation 6b associé à la masse oscillante 2b (figures 1 et 2). Sur les figures 1 et 2, les ressorts de suspension 3a, 3b ont leur axe de plus faible raideur orienté dans la direction d'excitation Ox et chaque ressort de suspension 3a, 3b disposé sur les côtés opposés 7a, 7b des masses oscillantes 2a, 2b est couplé avec un autre ressort de suspension 3a, 3b qui lui fait face.

Sur la figure 2, les ressorts de suspension 3a, 3b sont en forme de serpentin avec une pluralité de branches successives en U. Une extrémité de chaque ressort de suspension 3a, 3b est solidaire, respectivement, du cadre d'excitation 6a, 6b et une autre extrémité de chaque ressort de suspension 3a, 3b est solidaire du substrat par l'intermédiaire du point d'ancrage 4a, 4b correspondant.

Sur la figure 2, les deux ressorts 3a, 3b sont couplés par une barre de couplage 11 rigide, présentant deux sections 11a, 11b, reliées, respectivement, aux ressorts 3a et 3b. La barre de couplage 11 est articulée en rotation autour d'un pivot vertical 12, solidaire du substrat.

La dernière branche des ressorts de suspension 3a, 3b présente une première extrémité fixée sur le point d'ancrage 4a, 4b correspondant et une seconde extrémité mobile. La barre de couplage 11 connecte, de préférence, l'extrémité mobile de la dernière branche en U des ressorts de suspension 3a, 3b.

Par ailleurs, comme représenté sur la figure 2, l'ensemble des extrémités des branches en U des ressorts de suspension 3a, 3b ont, de préférence, une section transversale plus épaisse, de manière à former une base 15 sensiblement pleine pour chaque branche en U des ressorts de suspension 3a, 3b. L'ensemble des branches des ressorts de suspension 3a, 3b sont donc parallèles en position de repos et reliées par leurs bases 15, formant des zones locales de non-déformation. Une sollicitation en traction ou en compression des ressorts de suspension 3a, 3b entraîne alors la déformation des branches, à savoir la flexion des branches, uniquement entre deux bases 15 successives des branches en U.

Comme représenté sur la figure 2, la barre de couplage 11 est reliée, de préférence, aux extrémités mobiles épaisses des dernières branches des ressorts de suspension 3a, 3b. La barre de couplage 11 relie les ressorts de suspension 3a, 3b de façon symétrique par rapport à l'axe AA passant sensiblement par le centre des ressorts de suspension 3a, 3b, afin de permettre notamment un déplacement identique des ressorts de suspension 3a, 3b, lors du mouvement en opposition de phase des masses oscillantes 2a, 2b associées.

Par ailleurs, dans le mode particulier de réalisation des figures 1 à 5, dans lequel les points d'ancrage 4a, 4b des masses oscillantes 2a, 2b associées sont placés en opposition les uns par rapport aux autres, de part et d'autre de l'axe AA parallèle à la direction d'excitation et passant sensiblement par le centre des ressorts de suspension 3a, 3b disposés en regard (figure 2), les ressorts de suspension 3a, 3b sont reliées sur des zones symétriques par rapport au pivot vertical 12 de la barre de couplage 11. Ainsi, les extrémités mobiles des dernières branches des ressorts de suspension 3a, 3b sont disposées de part et d'autre de l'axe AA, définissant l'axe de plus faible raideur des ressorts de suspension 3a, 3b (figures 1 et 2). Les dernières branches des ressorts de suspension 3a, 3b sont donc orientées « en opposition ».

Une telle configuration, avec les ressorts de suspension 3a, 3b des masses oscillantes 2a, 2b reliés « en opposition » par les barres de couplage 11, de façon symétrique sur des zones ayant une même amplitude de déplacement, offre alors un fonctionnement optimal du microgyromètre 1, l'amplitude de déplacement des ressorts de suspension 3a, 3b étant identique pour les deux masses oscillantes 2a, 2b.

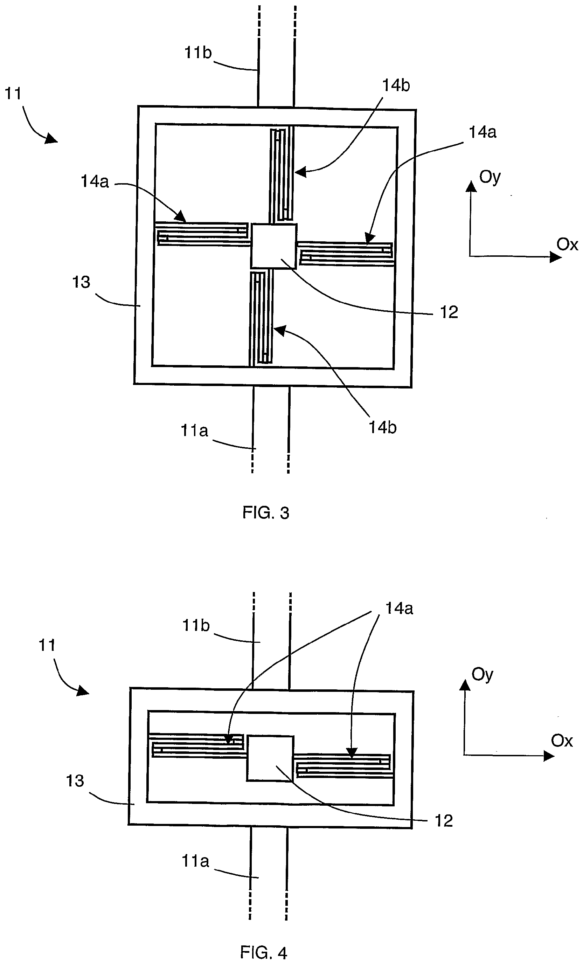

Sur la figure 3, représentant un mode particulier de réalisation de l'articulation en rotation de chaque barre de couplage 11 du microgyromètre 1, la barre de couplage 11 comporte un cadre 13 rigide, par exemple de forme carrée, sur lequel sont reliées les premières extrémités des sections 11a, 11b de la barre 11. Les secondes extrémités des sections 11a, 11b, reliées aux ressorts de suspension 3a, 3b correspondants, ne sont pas représentées sur les figures 3 à 5 pour des raisons de clarté.

Le pivot vertical 12, par exemple de forme carrée, est disposé au centre du cadre 13 et relié au cadre 13 par l'intermédiaire de quatre ressorts d'articulation 14 élastiques, disposés à l'intérieur du cadre 13. Les ressorts d'articulation 14 sont, de préférence, identiques aux ressorts de suspension 3a et 3b des masses oscillantes 2a, 2b. Deux premiers ressorts d'articulation 14a ont un axe de plus faible raideur orienté perpendiculairement à la direction d'excitation Ox et sont disposés de part et d'autre du pivot 12, parallèlement à la direction d'excitation Ox. Chaque ressort d'articulation 14a comporte une première extrémité reliée au cadre 13 et une seconde extrémité reliée au pivot 12.

Deux seconds ressorts d'articulation 14b, disposés perpendiculairement aux premiers ressorts d'articulation 14a, à savoir dans la direction longitudinale de la barre de couplage 11, sont disposés de part et d'autre du pivot 12 et ont un axe de plus faible raideur orienté dans la direction d'excitation Ox. Chaque ressort d'articulation 14b comporte une première extrémité reliée au cadre 13 et une seconde extrémité reliée au pivot 12. Cette configuration des ressorts d'articulations 14a, 14b permet notamment une bonne articulation en rotation de la barre de couplage 11.

Dans la variante de réalisation représentée sur la figure 4, la barre de couplage 11 de distingue de celle décrite précédemment par le cadre 13 rigide, de forme sensiblement rectangulaire, et par le nombre de ressorts d'articulation 14. En effet, le cadre 13 est relié au pivot 12, disposé en son centre, uniquement par les deux ressorts d'articulation 14a, disposés à l'intérieur du cadre 13 de part et d'autre du pivot 12. Les deux ressorts d'articulation 14a sont, de préférence, identiques aux ressorts d'articulations 14a représentés sur la figure 3. Cette configuration des ressorts d'articulation 14a est notamment utilisée dans le cas où il n'y a pas de déplacement de la barre de couplage 11 selon l'axe Oy, lors de l'oscillation des masses oscillantes 2a, 2b.

Sur les figures 3 et 4, les ressorts d'articulations 14a, 14b sont, de préférence, du même type que les ressorts de suspension 3a, 3b des masses oscillantes 2a, 2b, à savoir en forme de serpentin présentant, dans un même plan parallèle au substrat, une ou plusieurs branches successives en U.

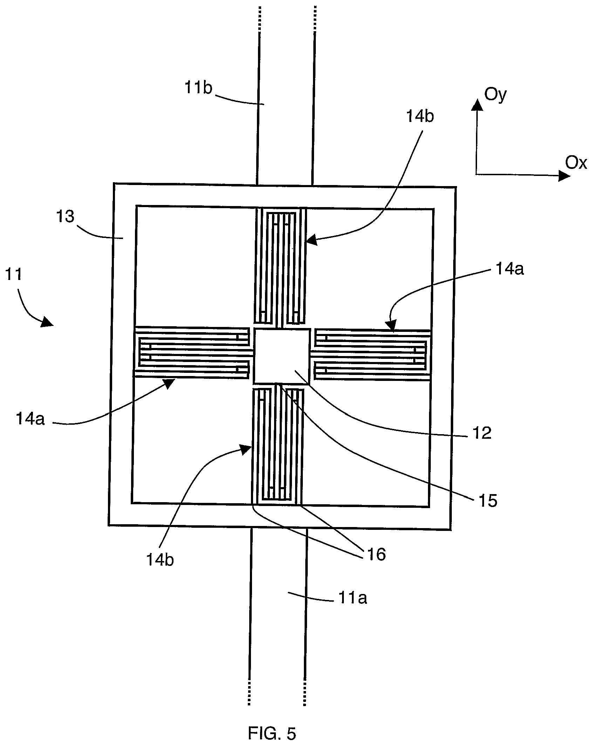

Dans la variante de réalisation représentée sur la figure 5, la barre de couplage 11 se distingue des barres de couplage 11 représentées sur les figures 3 et 4 par les ressorts d'articulations 14. Sur la figure 5, les ressorts d'articulation 14a et 14b disposés perpendiculairement les uns par rapport aux autres comme décrits sur la figure 3, comportent chacun une première extrémité 15 reliée au pivot 12, disposé au centre du cadre 13, et deux autres extrémités 16 reliées au cadre 13.

Chaque ressort d'articulation 14 forme ainsi un ressort plus compact avec deux branches en U, symétriques par rapport à l'extrémité 15 de la branche du ressort 14 reliée au pivot 12. Une telle configuration des ressorts de suspension 14, avec une extrémité 15 reliée au pivot 12 et deux extrémités 16 reliées au cadre 13, permet notamment une symétrie du système en rotation de la barre de couplage 11.

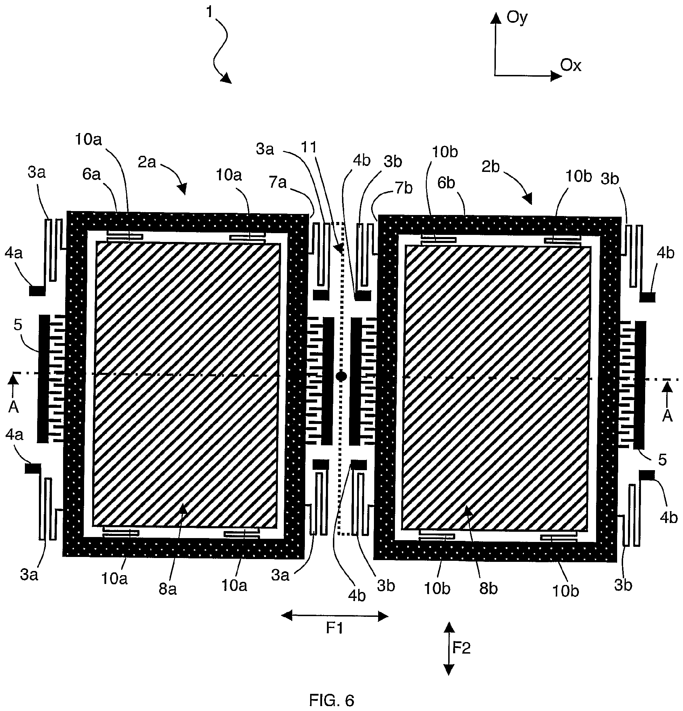

Sur la figure 6, la variante de réalisation de la microstructure selon l'invention du microgyromètre 1 se distingue du microgyromètre 1 représenté sur la figure 1 par la barre de couplage 11 reliant les ressorts de suspension 3a, 3b des masses oscillantes 2a, 2b. Chaque masse oscillante 2a, 2b comporte deux ressorts de suspension 3a, 3b sur son côté 7a, 7b, à savoir un ressort de suspension 3a, 3b vers chaque bord des côtés opposés 7a, 7b. La barre de couplage 11 connecte un ressort de suspension 3a de la masse oscillante 2a, disposé vers un premier bord du côté 7a, au ressort de suspension 3b de la masse oscillante 2b, disposé vers un second bord du côté opposé 7b.

La barre de couplage 11 connecte ainsi deux ressorts de suspension 3a, 3b disposés en opposition sur les côtés opposés 7a et 7b et disposés de part et d'autre d'un axe AA, passant par la partie centrale des masses oscillantes 2a, 2b, parallèlement à la direction d'excitation Ox. La barre de couplage 11 est ainsi plus longue que les barres de couplage 11 représentées sur la figure 1 et l'articulation en rotation de la barre de couplage 11 s'effectue de la même façon que précédemment, selon les différents modes de réalisation représentés sur les figures 3 à 5.

Dans le mode particulier de réalisation de la figure 6, les points d'ancrage 4a, 4b des ressorts de suspension 3a, 3b des masses oscillantes 2a, 2b sont disposés vers la partie centrale des masses oscillantes 2a, 2b. L'ensemble des ressorts de suspension 3a, 3b des masses oscillantes 2a, 2b sont donc symétriques par rapport à la barre de couplage 11. Il en résulte notamment une fabrication plus simple d'un tel microgyromètre 1.

Par ailleurs, les points d'ancrage 4a, 4b étant placés sensiblement au centre du microgyromètre 1, et de part et d'autre de l'axe AA parallèle à la direction d'excitation et passant sensiblement par le centre du microgyromètre 1, la barre de couplage 11 relie les extrémités mobiles, de préférence plus épaisses que le reste des branches, comme représenté sur la figure 2, des dernières branches des ressorts de suspension 3a, 3b associés, placés de part et d'autre de l'axe AA, sur les bords opposés 7a, 7b des masses oscillantes 2a, 2b associées. Comme précédemment, cette configuration du microgyromètre 1, avec une liaison croisée et symétrique de zones prédéterminées des ressorts de suspension 3a, 3b de même amplitude de déplacement permet notamment de conserver une amplitude de déplacement identique des ressorts de suspension 3a, 3b, pour optimiser le fonctionnement du microgyromètre 1.

D'une façon générale, quel que soit le mode de réalisation du microgyromètre 1 (figures 1 et 6) et quel que soit le mode de réalisation de l'articulation en rotation de la barre de couplage 11 (figures 3 à 5), les ressorts de suspension 3a, 3b sont couplés au niveau d'une zone intermédiaire de connexion, définie par un point situé entre leur extrémité fixée au cadre d'excitation 6a, 6b et leur extrémité fixée au point d'ancrage 4a, 4b correspondant.

Le couplage par les ressorts de suspension 3a, 3b permet notamment d'obtenir un couplage des masses oscillantes 2a, 2b sans obligation d'un déplacement exactement identique des deux masses oscillantes 2a, 2b. Le microgyromètre 1 accepte alors des variations technologiques légères entre les deux masses oscillantes 2a, 2b.

Par ailleurs, le pivot 12 d'articulation en rotation (figures 3 à 5) force le déplacement des deux masses oscillantes 2a, 2b en opposition de phase, qui correspond alors au premier mode de résonance du microgyromètre 1 (figures 1 et 6). Il en résulte une certaine liberté quant à l'amplitude de vibration, ce qui donne plus de souplesse au microgyromètre 1.

Le couplage « en opposition » des ressorts de suspension 3a, 3b (figures 1 et 6) permet ainsi d'optimiser le fonctionnement du microgyromètre 1, avec un mouvement en opposition de phase forcé. De plus, la barre de couplage 11 et le pivot 12 d'articulation en rotation offrent plus de souplesse au fonctionnement du microgyromètre 1 (figures 3 à 5).

De plus, le déplacement de la barre de couplage 11 en rotation est réduit par rapport au déplacement des masses oscillantes 2a, 2b, notamment en fonction du nombre de branches en U du serpentin constituant les ressorts de suspension 3a, 3b. La raideur mécanique de l'articulation en rotation est alors moins critique.

Le microgyromètre, comme représenté sur les figures 1 et 6, présente ainsi un fonctionnement optimisé, notamment grâce au couplage mécanique des masses oscillantes 2a, 2b au niveau de leurs ressorts de suspension 3a, 3b. De plus, la barre de couplage 11 rigide et le pivot 12 d'articulation en rotation permettent de forcer le mode de vibration en opposition de phase, afin d'assurer une bonne efficacité des mesures de la force de Coriolis.

L'invention n'est pas limitée aux différents modes de réalisation décrits ci-dessus. La position de la zone intermédiaire des ressorts de suspension 3a, 3b correspondants, pour la connexion de la barre de couplage 11, peut être différente, tant qu'elle permet de forcer le mode de vibration en opposition de phase des masses oscillantes 2a, 2b.

Les peignes capacitifs interdigités 5 des masses oscillantes 2a, 2b peuvent être remplacés par tout autre moyen d'excitation, entraînant la vibration des masses oscillantes 2a, 2b dans la direction d'excitation Ox.

Les ressorts de suspension 3a, 3b peuvent être remplacés par tout autre type de moyens élastiques de suspension, tant qu'ils permettent un couplage mécanique des masses oscillantes 2a, 2b et un fonctionnement optimal du microgyromètre 1.

La forme et le type des ressorts d'articulation 14 peuvent être différents, tant qu'ils permettent une bonne articulation en rotation de la barre de couplage 11.

## Revendications

1. Microsystème (1) réalisé dans un substrat plan pour la mesure d'une vitesse de rotation selon un axe perpendiculaire au substrat et comportant :
- au moins deux masses oscillantes (2a, 2b), suspendues par rapport au substrat par au moins une paire de moyens élastiques de suspension (3a, 3b) fixés à des points d'ancrage (4a, 4b), les au moins deux masses oscillantes (2a, 2b) définissant au moins deux cadres d'excitation (6a, 6b) entourant chacun une électrode mobile (8a, 8b), chaque électrode mobile (8a, 8b) étant reliée au cadre d'excitation (6a, 6b) associé par des ressorts élastiques de rappel (10a, 10b) pour être mobile par rapport au cadre d'excitation (6a, 6b) associé selon une première direction (Oy),
- des moyens d'excitations (5) des au moins deux masses oscillantes (2a, 2b) configurés pour appliquer une force d'excitation (F1) selon une direction d'excitation prédéterminée (Ox), les moyens d'excitations (5) étant disposés selon des premiers côtés opposés des au moins deux cadres d'excitation (6a, 6b) selon la direction d'excitation prédéterminée (Ox), la première direction (Oy) étant perpendiculaire à la direction d'excitation prédéterminée (Ox) et les directions (Ox) et (Oy) étant parallèles au plan du substrat,
- et des moyens de couplage des au moins deux masses oscillantes (2a, 2b), aptes à produire un mouvement en opposition de phase des au moins deux masses oscillantes (2a, 2b), lors de leur excitation selon la direction d'excitation prédéterminée (Ox),
microsystème **caractérisé en ce que** :
- la au moins une paire de moyens élastiques de suspension (3a, 3b), comporte deux paires de moyens élastiques de suspension (3a,3b) disposés sur chaque côté opposé (7a, 7b) de deux cadres d'excitation (6a, 6b) adjacents des au moins deux cadres d'excitation (6a, 6b) et ayant un axe de plus faible raideur orienté dans ladite direction d'excitation (Ox), les côtés opposés se faisant face et étant opposés selon la direction d'excitation (Ox),
- lesdits moyens de couplage possèdent au moins une barre de couplage rigide (11) qui connecte des zones intermédiaires desdites deux paires de moyens élastiques de suspension (3a, 3b) disposés entre lesdites au moins deux masses oscillantes (2a, 2b),
- chaque zone intermédiaire est disposée entre une première extrémité des moyens élastiques de suspension (3a, 3b) associés, fixée sur le cadre d'excitation (6a, 6b) correspondant, et une seconde extrémité des moyens élastiques de suspension (3a, 3b) associés, fixée sur le substrat par un point d'ancrage (4a, 4b) correspondant,
- lesdites zones intermédiaires, connectées par les moyens de couplage, sont disposées de part et d'autre d'un axe (AA) parallèle à la direction d'excitation (Ox).

2. Microsystème selon la revendication 1, **caractérisé en ce que** les deux paires de moyens élastiques de suspension (3a, 3b) comportent une pluralité de branches dans un même plan parallèle au substrat et **en ce que** chaque zone intermédiaire est constituée par une extrémité mobile d'une dernière branche des deux paires de moyens élastiques de suspension (3a, 3b) associés, ladite dernière branche étant fixée au point d'ancrage (4a, 4b) correspondant.

3. Microsystème selon l'une des revendications 1 et 2, **caractérisé en ce que** la barre de couplage (11) est articulée en rotation autour d'un pivot (12), solidaire du substrat, et comporte deux sections (11a, 11b) reliées, respectivement, aux zones intermédiaires des deux paires de moyens élastiques de suspension (3a, 3b) associés.

4. Microsystème selon la revendication 3, **caractérisé en ce que** la barre de couplage (11) comporte :
- un cadre (13) rigide, sur lequel sont fixées les deux sections (11a, 11b) de la barre de couplage (11), le pivot (12) étant disposé au centre du cadre (13),
- et des ressorts d'articulation (14), disposés à l'intérieur du cadre (13) et comprenant chacun au moins une première extrémité reliée au cadre (13) et au moins une seconde extrémité relié au pivot (12).

5. Microsystème selon la revendication 4, **caractérisé en ce que** la barre de couplage (11) comporte au moins deux premiers ressorts d'articulation (14a), disposés de part et d'autre du pivot (12) et ayant un axe de plus faible raideur orienté perpendiculairement à la direction d'excitation (Ox).

6. Microsystème selon la revendication 5, **caractérisé en ce que** la barre de couplage (11) comporte deux seconds ressorts d'articulation (14b), disposés de part et d'autre du pivot (12), perpendiculairement aux premiers ressorts d'articulation (14a), et ayant un axe de plus faible raideur orienté dans la direction d'excitation (Ox).

7. Microsystème selon l'une quelconque des revendications 4 à 6, **caractérisé en ce que** les ressorts d'articulation (14) sont des ressorts en forme de serpentin.

8. Microsystème selon l'une quelconque des revendications 1 à 7, **caractérisé en ce que** les côtés opposés (7a, 7b) des au moins deux masses oscillantes (2a, 2b) comportent chacun deux moyens élastiques de suspension (3a, 3b) disposés en regard les uns des autres selon la direction d'excitation (Ox).

9. Microsystème selon la revendication 8, **caractérisé en ce que** les points d'ancrage (4a, 4b) des deux moyens élastiques de suspension (3a, 3b) disposés en regard sont situés de part et d'autre de l'axe (AA) parallèle à la direction d'excitation, passant par le centre des deux moyens élastiques de suspension (3a, 3b) disposés en regard, et les moyens de couplage connectent les zones intermédiaires de chaque paire de moyens élastiques de suspension (3a, 3b) disposés en regard.

10. Microsystème selon la revendication 8, **caractérisé en ce que** les points d'ancrage (4a, 4b) des deux moyens élastiques de suspension (3a, 3b) disposés en regard se font face d'un même côté de l'axe (AA) parallèle à la direction d'excitation et les moyens de couplage connectent les zones intermédiaires des paires de moyens élastiques de suspension (3a, 3b) disposés de part et d'autre dudit axe (AA), lequel passe sensiblement par le centre du microsystème (1).

11. Microsystème selon l'une quelconque des revendications 1 à 10, **caractérisé en ce que** les moyens élastiques de suspension sont des ressorts de suspension (3a, 3b) en forme de serpentin.

## Patentansprüche

1. Mikrosystem (1), das in einem flachen Substrat zum Messen einer Drehgeschwindigkeit entlang einer auf das Substrat senkrechten Achse hergestellt ist, umfassend:
- mindestens zwei Schwungmassen (2a, 2b), die in Bezug zum Substrat durch mindestens ein Paar von elastischen Aufhängungsmitteln (3a, 3b), die an Verankerungspunkten (4a, 4b) befestigt sind, aufgehängt sind, wobei die mindestens zwei Schwungmassen (2a, 2b) mindestens zwei Erregungsrahmen (6a, 6b) definieren, die jeweils eine mobile Elektrode (8a, 8b) umgeben, wobei jede mobile Elektrode (8a, 8b) mit dem zugeordneten Erregungsrahmen (6a, 6b) durch elastische Rückstellfedern (10a, 10b) verbunden ist, um in Bezug zum zugeordneten Erregungsrahmen (6a, 6b) in eine erste Richtung (Oy) mobil zu sein,
- Erregungsmittel (5) der mindestens zwei Schwungmassen (2a, 2b), die eingerichtet sind, um eine Erregungskraft (F1) entlang einer vorbestimmten Erregungsrichtung (Ox) anzulegen, wobei die Erregungsmittel (5) entlang erster entgegengesetzt liegender Seiten der mindestens zwei Erregungsrahmen (6a, 6b) entlang der vorbestimmten Erregungsrichtung (Ox) angeordnet sind, wobei die erste Richtung (Oy) auf die vorbestimmte Erregungsrichtung (Ox) senkrecht ist, und wobei die Richtungen (Ox) und (Oy) zur Ebene des Substrats parallel sind,
- und Kopplungsmittel der mindestens zwei Schwungmassen (2a, 2b), die geeignet sind, eine gegenphasige Bewegung der mindestens zwei Schwungmassen (2a, 2b) bei ihrer Erregung entlang der vorbestimmten Erregungsrichtung (Ox) zu erzeugen, wobei das Mikrosystem **dadurch gekennzeichnet ist, dass**:
- das mindestens eine Paar von elastischen Aufhängungsmitteln (3a, 3b) zwei Paare von elastischen Aufhängungsmitteln (3a, 3b) umfasst, die auf jeder entgegengesetzt liegenden Seite (7a, 7b) von zwei aneinandergrenzenden Erregungsrahmen (6a, 6b) der mindestens zwei Erregungsrahmen (6a, 6b) angeordnet sind, mit einer Achse von geringerer Steifigkeit, de in die Erregungsrichtung (Ox) gerichtet ist, wobei die entgegengesetzten Seiten einander gegenüberliegen und in Erregungsrichtung (Ox) entgegengesetzt sind,
- die Kopplungsmittel mindestens eine starre Kopplungsstange (11) besitzen, die Zwischenzonen der zwei Paare von elastischen Aufhängungsmitteln (3a, 3b) verbindet, die zwischen den mindestens zwei Schwungmassen (2a, 2b) angeordnet sind,
- jede Zwischenzone zwischen einem ersten Ende der zugeordneten elastischen Aufhängungsmittel (3a, 3b), das auf dem entsprechenden Erregungsrahmen (6a, 6b) befestigt ist, und einem zweiten Ende der zugeordneten elastischen Aufhängungsmittel (3a, 3b), das auf dem Substrat durch einen entsprechenden Verankerungspunkt (4a, 4b) befestigt ist, angeordnet ist,
- die Zwischenzonen, die durch die Kopplungsmittel verbunden sind, beiderseits einer Achse (AA) parallel zur Erregungsrichtung (Ox) angeordnet sind.

2. Mikrosystem nach Anspruch 1, **dadurch gekennzeichnet, dass** die zwei Paare von elastischen Aufhängungsmitteln (3a, 3b) eine Vielzahl von Schenkeln in einer selben Ebene parallel zum Substrat umfassen, und dass jede Zwischenzone von einem mobilen Ende eines letzten Schenkels der zugeordneten zwei Paare von elastischen Aufhängungsmitteln (3a, 3b) gebildet ist, wobei der letzte Schenkel am entsprechenden Verankerungspunkt (4a, 4b) befestigt ist.

3. Mikrosystem nach einem der Ansprüche 1 und 2, **dadurch gekennzeichnet, dass** die Kopplungsstange (11) drehbar um einen Zapfen (12), der mit dem Substrat verbunden ist, angelenkt ist und zwei Abschnitte (11a, 11b) umfasst, die jeweils mit den Zwischenzonen der zugeordneten zwei Paare von elastischen Aufhängungselementen (3a, 3b) verbunden sind.

4. Mikrosystem nach Anspruch 3, **dadurch gekennzeichnet, dass** die Kopplungsstange (11) umfasst:
- einen starren Rahmen (13), auf dem die zwei Abschnitte (11a, 11b) der Kopplungsstange (11) befestigt sind, wobei der Zapfen (12) in der Mitte des Rahmens (13) angeordnet ist,
- und Anlenkfedern (14), die innerhalb des Rahmens (13) angeordnet sind und jeweils mindestens ein erstes Ende, das mit dem Rahmen (13) verbunden ist, und mindestens ein zweites Ende, das mit dem Zapfen (12) verbunden ist, umfassen.

5. Mikrosystem nach Anspruch 4, **dadurch gekennzeichnet, dass** die Kopplungsstange (11) mindestens zwei erste Anlenkfedern (14a) umfasst, die beiderseits des Zapfens (12) angeordnet sind und eine Achse mit geringerer Steifigkeit haben, die senkrecht auf die Erregungsrichtung (Ox) ausgerichtet ist.

6. Mikrosystem nach Anspruch 5, **dadurch gekennzeichnet, dass** die Kopplungsstange (11) zwei zweite Anlenkfedern (14b) umfasst, die beiderseits des Zapfens (12) senkrecht auf die ersten Anlenkfedern (14a) angeordnet sind und eine Achse von geringerer Steifigkeit haben, die in Erregungsrichtung (Ox) ausgerichtet sind.

7. Mikrosystem nach einem der Ansprüche 4 bis 6, **dadurch gekennzeichnet, dass** die Anlenkfedern (14) spiralförmige Federn sind.

8. Mikrosystem nach einem der Ansprüche 1 bis 7, **dadurch gekennzeichnet, dass** die entgegengesetzt liegenden Seiten (7a, 7b) der mindestens zwei Schwungmassen (2a, 2b) jeweils zwei elastische Aufhängungsmittel (3a, 3b) umfassen, die einander gegenüberliegend in Erregungsrichtung (Ox) angeordnet sind.

9. Mikrosystem nach Anspruch 8, **dadurch gekennzeichnet, dass** die Verankerungspunkte (4a, 4b) der zwei einander gegenüberliegenden elastischen Aufhängungsmittel (3a, 3b) beiderseits der Achse (AA) parallel zur Erregungsrichtung angeordnet sind, die durch die Mitte der zwei einander gegenüberliegenden elastischen Aufhängungsmittel (3a, 3b) verläuft, und die Kopplungsmittel die Zwischenzonen jedes Paars von einander gegenüberliegenden elastischen Aufhängungsmitteln (3a, 3b) verbinden.

10. Mikrosystem nach Anspruch 8, **dadurch gekennzeichnet, dass** die Verankerungspunkte (4a, 4b) der zwei einander gegenüberliegenden elastischen Aufhängungsmittel (3a, 3b) einer selben Seite der Achse (AA) parallel zur Erregungsrichtung gegenüberliegen, und die Kopplungsmittel die Zwischenzonen der Paare von elastischen Aufhängungsmitteln (3a, 3b), die beiderseits der Achse (AA), die im Wesentlichen durch die Mitte des Mikrosystems (1) verläuft, angeordnet sind, verbinden.

11. Mikrosystem nach einem der Ansprüche 1 bis 10, **dadurch gekennzeichnet, dass** die elastischen Aufhängungsmittel spiralförmige Aufhängungsfedern (3a, 3b) sind.

## Claims

1. A microsystem (1) made in a flat substrate for measuring a rotation rate according to axis perpendicular to the substrate and comprising:
- at least two oscillating masses (2a, 2b), suspended with respect to the substrate by at least one pair of elastic suspension means (3a, 3b) fixed to anchoring points (4a, 4b), the at least two oscillating masses (2a, 2b) defining at least two excitation frames (6a, 6b) each surrounding a movable electrode (8a, 8b), each movable electrode (8a, 8b) being connected to the associated excitation frame (6a, 6b) by elastic return springs (10a, 10b) to be movable with respect to the associated excitation frame (6a, 6b) along a first direction (Oy),
- excitation means (5) of the at least two oscillating masses (2a, 2b) configured to apply an excitation force (F1) along a predetermined excitation direction (Ox), the excitation means (5) being disposed along opposite first sides of the at least two excitation frames (6a, 6b) along the predetermined excitation direction (Ox), the first direction (Oy) being perpendicular to the predetermined excitation direction (Ox) and the directions (Ox) and (Oy) being parallel to the plane of the substrate,
- and means for coupling the at least two adjacent oscillating masses (2a, 2b), capable of producing a movement in phase opposition of said at least two oscillating masses (2a, 2b), when they are excited in a predetermined excitation direction (Ox),
microsystem **characterized in that**:
- the at least one pair of elastic suspension means (3a, 3b) comprises two pairs of elastic suspension means (3a, 3b) arranged on each opposite sides (7a, 7b) of two adjacent excitation frames (6a, 6b) of the at least two excitation frames (6a, 6b) and having an axis of least stiffness oriented in said excitation direction (Ox), the opposite sides facing each other et being opposite along the excitation direction (Ox),
- said coupling means have at least one rigid coupling bar (11) connecting intermediate zones of said two pairs of elastic suspension means (3a, 3b) arranged between said at least two oscillating masses (2a, 2b),
- each intermediate zone is arranged between a first end of the associated elastic suspension means (3a, 3b) fixed onto the corresponding excitation frame (6a, 6b), and a second end of the associated elastic suspension means (3a, 3b) fixed onto the substrate by a corresponding anchoring point (4a, 4b),
- said intermediate zones, connected by the coupling means, are arranged on each side of an axis (AA) parallel to the excitation direction (Ox).

2. The microsystem according to claim 1, **characterized in that** the two pairs of elastic suspension means (3a, 3b) comprise a plurality of branchs, in a same plane parallel to the substrate, and **in that** each intermediate zone is formed by a mobile end of a last branch of the associated two pairs of elastic suspension means (3a, 3b), said last branch being fixed to the corresponding anchoring point (4a, 4b).

3. The microsystem according to one of claims 1 and 2, **characterized in that** the coupling bar (11) is articulated in rotation around a pivot (12) firmly secured to the substrate and comprising two sections (11a, 11b) respectively connected to the intermediate zones of the two pairs of associated elastic suspension means (3a, 3b).

4. The microsystem according to claim 3, **characterized in that** the coupling bar (11) comprises:
- a rigid frame (13) on which the two sections (11a, 11b)of the coupling bar (11) are fixed, the pivot (12) being arranged in the centre of the frame (13),
- and articulation springs (14) arranged inside the frame (13) and each comprising at least one first end connected to the frame (13) and at least one second end connected to the pivot (12).

5. The microsystem according to claim 4, **characterized in that** the coupling bar (11) comprises at least two first articulation springs (14a) arranged on each side of the pivot (12) and having an axis of least stiffness oriented perpendicularly to the excitation direction (Ox).

6. The microsystem according to claim 5, **characterized in that** the coupling bar (11) comprises two second articulation springs (14b), arranged on each side of the pivot (12), perpendicularly to the first articulation springs (14a), and having an axis of least stiffness oriented in the excitation direction (Ox).

7. The microsystem according to any one of claims 4 to 6, **characterized in that** the articulation springs (14) are springs in the form of meanders.

8. The microsystem according to any one of claims 1 to 7, **characterized in that** the opposite sides (7a, 7b) of the at least two oscillating masses (2a, 2b) each comprise two elastic suspension means (3a, 3b) arranged facing one another according to the excitation direction (Ox).

9. The microsystem according to claim 8, **characterized in that** the anchoring points (4a, 4b) of the two elastic suspension means (3a, 3b) arranged facing one another are situated on each side of the axis (AA) parallel to the excitation direction, passing through the centre of the two elastic suspension means (3a, 3b) arranged facing one another, and the coupling means connect the intermediate zones of each pair of elastic suspension means (3a, 3b) arranged facing one another.

10. The microsystem according to claim 8, **characterized in that** the anchoring points (4a, 4b) of the two elastic suspension means (3a, 3b) arranged facing one another face one another on the same side of the axis (AA) parallel to the excitation direction and the coupling means connect the intermediate zones of the pairs of elastic suspension means (3a, 3b) arranged on each side of said axis (AA), which passes substantially through the centre of the microsystem (1).

11. The microsystem according to any one of claims 1 to 10, **characterized in that** the elastic suspension means are suspension springs (3a, 3b) in the form of meanders.
